# FASCICULE DE BREVET EUROPEEN

(11) **EP 2 043 103 B1**
(45) Date de publication et mention de la délivrance du brevet: **06.04.2016**
(21) Numéro de dépôt: 08290870.8
(22) Date de dépôt: 16.09.2008
(51) Int. Cl.: G11C 7/10, G11C 7/22, G06F 12/08

(54) **Dispositif de mémoire électronique**
Elektronische Speichervorrichtung
Electronic memory device

(30) Priorité: 26.09.2007 FR 0706740
(43) Date de publication de la demande: 01.04.2009
(73) Titulaire: Qualcomm Technologies, Inc., San Diego, CA 92121 (US)
(72) Inventeur: Boucard, Philippe, 78150 Le Chesnay (FR); Godet, Pascal, 78350 Jouy en Josas (FR); Montperrus, Luc, 78180 Montigny le Bretonneux (FR)
(74) Mandataire: Wegner, Hans

(56) Documents cités:
- EP-A- 0 588 369
- EP-A- 0 762 287
- US-B1- 6 381 671

## Description

L'invention concerne un dispositif de mémoire électronique.

La progression continue des technologies a abouti à l'intégration de systèmes sur puce de semi-conducteur de plus en plus complexes, systèmes qui sont constitués de nombreux modules fonctionnels.

Les besoins en mémoire dans de tels systèmes intégrés sur puce ont parallèlement évolué de manière croissante. Cette évolution a favorisé l'appel aux mémoires de grandes capacités connues sous le nom de DRAM.

Pour répondre à ces besoins croissants, des mémoires dites DRAM embarquées ont d'abord été développées, en mélangeant les technologies de mémoire DRAM et les technologies de type processus logique.

Cependant, pour des raisons de coût et de conception, les mémoires DRAM embarquées ont du être majoritairement abandonnées au profit des DRAM sur des puces dédiées.

De telles DRAM séparées de la puce du système sont accessibles par des interfaces physiques de bas niveau, par exemple de type DDR pour les plus courantes ou de type Rambus (nom déposé) pour les plus performantes.

Les documents US 6 381 671 et EP 0 762 287 décrivent des mémoires de ces types.

L'accroissement des besoins en mémoires de grande capacité a donc pour conséquence un nombre accru d'interfaces de communication avec les DRAM sur la puce système et une constante augmentation des débits d'échange d'informations avec l'extérieur.

Les solutions adoptées pour les interfaces actuelles des DRAM présentent un certain nombre d'inconvénients.
D'abord ce sont des interfaces de bas niveau, c'est-à-dire qu'elles véhiculent les commandes élémentaires de la DRAM ainsi que leur séquencement sous forme de signaux ou de paquets de signaux, en respectant au cycle près les distances inter commandes spécifiées par les constructeurs de DRAM.

De plus, pour les interfaces les plus courantes, le nombre de signaux à transporter est assez élevé et en augmentation, aujourd'hui de 48 jusqu'à 160 signaux, et elles utilisent généralement un lien mésochrone, ce qui les rend difficile à réaliser.

En outre, afin de limiter le nombre de signaux sur les interfaces DRAM, il est utilisé des bus bidirectionnels. Cependant, le temps de retournement du bus affecte alors les performances de l'interface, et un contrôleur mémoire doit organiser les accès de manière à minimiser le nombre de retournements du bus.

Pour résumer, les interfaces DRAM constituent aujourd'hui l'un des principaux facteurs limitants pour les performances du système.

L'invention vient améliorer la situation.
L'invention est définie par la revendication indépendante 1.
Plus particulièrement, l'invention a notamment pour but de rendre la mémoire plus facile à intégrer. A cet effet, un dispositif de mémoire électronique comporte un banc de mémoires muni d'un cache, et un séquenceur pour assurer les accès physiques audit banc de mémoires.

Le dispositif comporte en outre une interface physique pour recevoir des requêtes d'accès mémoire de haut niveau, et un gestionnaire de requêtes entre l'interface physique et le séquenceur.

Le gestionnaire de requêtes comprend une file d'attente d'entrée pour stocker les requêtes d'accès mémoire de haut niveau et une fonction d'arbitrage qui tient compte de données du cache et de données de la file d'attente d'entrée pour désigner une requête à exécuter, permettant ainsi de réaliser les bancs de mémoire, le séquenceur et le gestionnaire de requêtes sur une puce unique, l'interface physique assurant la connexion avec l'extérieur de la puce.

Un tel dispositif de mémoire électronique est particulièrement intéressant car il offre une puce de mémoire qui présente les avantages des mémoires de masse en termes de coûts et de performance, tout en assouplissant la gestion de leurs interfaces.

Une requête d'accès mémoire de haut niveau peut être un paquet d'informations avec un en-tête et éventuellement des données associées (écriture), comprenant dans l'en-tête un code opération (lecture ou écriture), une adresse dans le banc mémoire, une adresse de destination et une adresse pour retrouver l'expéditeur (s'il y en a plus d'un). L'en-tête contient les informations nécessaires pour router le paquet de façon autonome dans un réseau de transport.
En effet, ce dispositif permet, grâce au gestionnaire de requêtes et au séquenceur, de ne plus de piloter la mémoire avec des commandes de bas niveau, ce qui rend la mémoire plus autonome et plus intégrable.

D'autres caractéristiques et avantages de l'invention apparaîtront mieux à la lecture de la description qui suit, tirée d'exemples donnés à titre illustratif et non limitatif à partir des dessins sur lesquels :
- la figure 1 représente un motif de base d'une mémoire de type DRAM ;
- la figure 2 représente un schéma simplifié d'une architecture d'une mémoire DRAM à quatre banques de mémoire ;
- la figure 3 représente un dispositif de mémoire ;
- la figure 4 représente un diagramme d'une boucle de fonctionnement de la fonction d'arbitrage du dispositif de la figure 3 ;
- la figure 5 représente un diagramme d'un contrôle de flux qui a lieu dans le dispositif de la figure 3 ;
- la figure 6 représente un diagramme d'une opération de lecture ou d'écriture dans le dispositif de la figure 3 ;
- la figure 7 représente un diagramme d'une fonction appelée lors d'une opération décrite avec la figure 6 ; et
- la figure 8 représente un mode de réalisation en variante du dispositif de mémoire.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

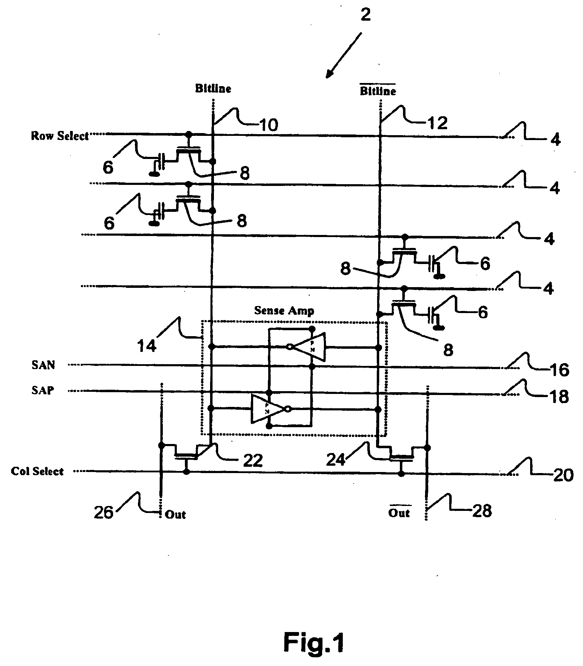

On a représenté sur la figure 1 un motif de base 2 d'une banque de mémoire de type DRAM. Le terme matrice peut également être utilisé pour désigner la DRAM, comme celle-ci est généralement vue comme un ensemble de colonnes et de rangées de capacités auxquelles on accède.

Le motif 2 comporte des lignes de sélection de rangée 4, également appelées Row Select Lines, des lignes de bits 10 et 12, également appelées Bitlines, des lignes de commande SAN 16 et SAP 18, une ligne de sélection de colonne 20, également appelée Column Select Lines, et des lignes de sortie 26 et 28.

Les lignes de sélection de rangée 4 permettent d'accéder à un ensemble de capacités 6 au moyen de transistors d'accès 8. Les transistors d'accès 8 sont organisés de façon telle que le potentiel de la capacité 6 peut être lu de façon différentielle sur les deux lignes de bits 10 et 12.

Les lignes de bit 10 et 12 sont préchargées et égalisées au préalable à la moitié du potentiel de l'alimentation, et l'une sert de référence à l'autre. La lecture différentielle des lignes de bits 10 et 12 est faite dans un amplificateur différentiel 14, également appelé Sense Amplifier, grâce aux lignes SAN 16 et SAP 18.

Les lignes SAN 16 et SAP 18 sont décalées entre-elles, et en retard sur la commande de sélection de rangée 4. Ce retard permet de limiter le courant de court circuit, responsable du principal pic de courant dans la DRAM, comme cela sera décrit plus bas.

L'amplificateur différentiel 14 a deux autres rôles :
- régénérer un potentiel correct sur les lignes de bits 10 et 12 et dans la capacité 6 accédée, comme le potentiel de cette dernière a été altéré pendant la lecture. Un mécanisme de pompe à charge peut permettre d'atteindre le niveau de l'alimentation derrière le transistor d'accès 8 le cas échéant ;
- faire office de point mémoire tant que l'information de la rangée 4 doit être exploitée.

Les lignes de sortie 26 et 28 comportent des transistors d'accès 22 et 24 qui permettent l'accès à la valeur du point mémoire. Les transistors d'accès 22 et 24 sont reliés à la ligne de sélection de colonne 20. Ladite ligne commande la lecture de la valeur du point mémoire. Le sous-ensemble accédé est appelé une colonne.

L'ensemble des amplificateurs différentiels 14 avec leurs transistors d'accès 22 et 24 sur les lignes de sorties 26 et 28 constitue une matrice de points mémoires classiques de type SRAM à six transistors.

L'accès d'une « rangée » de la DRAM initialise les valeurs de cette SRAM. L'accès « colonne » permet l'exploitation de ladite SRAM. On peut considérer que la matrice SRAM interne constitue une mémoire cache pour le banc mémoire DRAM.

Comme le temps d'accès d'une rangée est très long (plusieurs dizaines de ns), un grand nombre de bits sera lu, la taille d'une rangée pouvant atteindre 16 Kbits pour une DRAM de 1 Gbit. Le but est de trouver parmi les bits de la rangée un maximum d'accès colonne à exploiter, ces accès étant bien plus rapides que l'accès d'une rangée.

Une autre particularité de cette mémoire est la dégradation de l'information au cours du temps due aux diverses fuites, d'où le nom de mémoire dynamique. Pour compenser cette dégradation un rafraîchissement périodique de la matrice est nécessaire, comme cela apparaîtra plus bas.

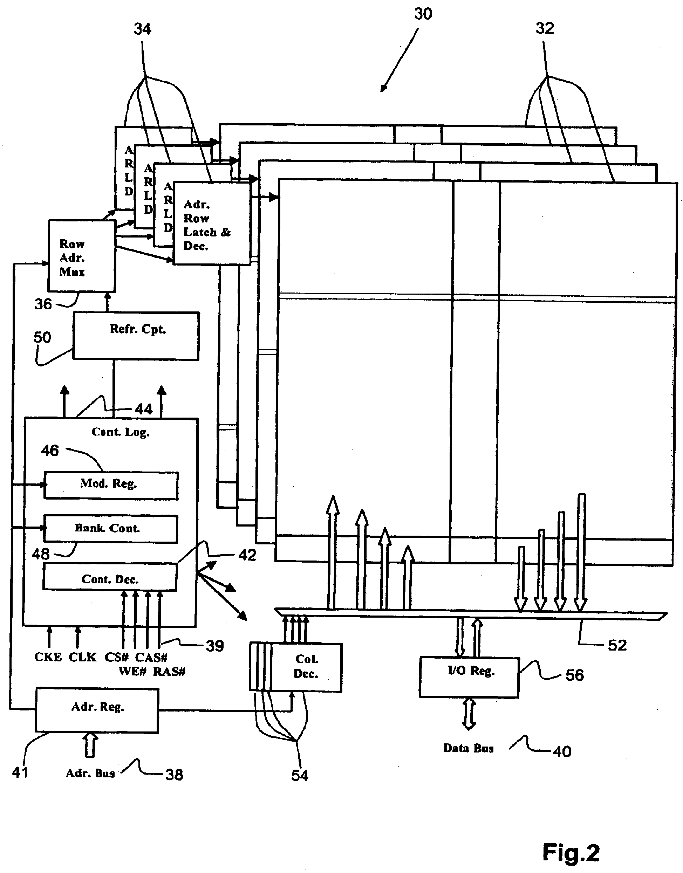

La figure 2 montre un schéma simplifié d'une architecture de DRAM 30 à quatre bancs 32 de mémoire ayant chacun ses propres décodeurs 34 qui sont reliés à un multiplexeur d'adresse de rangée 36. Le nombre de bancs de mémoire dans les DRAM peut être inférieur ou égal à huit.

En fonction des caractéristiques recherchées pour la DRAM, les quatre bancs 32 sont plus ou moins opérables de manière indépendante. Ainsi, pour obtenir une DRAM la plus performante possible, les bancs 32 seront totalement découplées.

En revanche, comme c'est le cas ici, les opérations sur les bancs 32 peuvent être couplées plus ou moins lâchement, pour des raisons de répartition des pics de consommation.

La DRAM 30 est commandée par une interface qui comprend un bus d'adresse 38, un bus de commande 39 et un bus de données 40. Le bus d'adresse 38 émet des signaux d'adresse qui sont stockés dans un registre d'adresse 41. Le bus de commande 39 émet des signaux de commande CS#, WE#, CAS# et RAS# qui sont décodés dans un décodeur de commande 42.

L'interface de la DRAM est synchronisée au moyen d'une horloge rapide CLK, qui permet d'exprimer chacune des opérations en un nombre de cycles de cette horloge. Un signal CKE est également reçu pour masquer ou valider l'horloge.

Sur la base de la combinaison des signaux CS#, WE#, CAS# et RAS# à l'instant d'échantillonnage de l'horloge, le décodeur 42 détermine la commande à effectuer.

Parmi les commandes les plus courantes on trouve :
- le repos ;
- le cycle sans opération ;
- la précharge ;
- l'activation, c'est-à-dire l'accès rangée, également appelé "activate" ;
- la lecture ou l'écriture d'une colonne ;
- la terminaison de salve d'écriture, également appelé "burst terminate" ;
- l'auto rafraîchissement ; et
- le chargement du registre de mode.

Les opérations associées à ces commandes peuvent en outre nécessiter la présence d'une adresse ou d'un code spécifique sur le bus d'adresse.

Les durées des opérations varient en fonction de l'enchaînement des commandes. Cela permet d'assurer le bon fonctionnement électrique aussi bien au niveau des matrices de cellules que pour la bonne utilisation du bus de données.

Il arrive que certaines durées découlent de besoins liés à des considérations de consommation. C'est par exemple le cas avec le tRRD, qui impose la durée entre deux commandes "activate", y compris sur des banques distinctes, ou bien encore avec le tFAW, qui impose une durée totale pour 4 commandes d'activation consécutives.

Le décodeur de commande 42 fait partie d'une logique de contrôle 44 qui comprend également un registre de mode 46 et un contrôleur de banc 48.

Le registre de mode 46 permet de configurer divers modes de fonctionnement. Il sert par exemple à définir la longueur des salves de données, également appelée "burst length", le cadrage des données, également appelé "wrap mode" ou encore la configuration électrique du bus de données 40.

La logique de contrôle 44 est reliée à un compteur de rafraîchissement 50. Le compteur de rafraîchissement 50 sert à mémoriser la position de la rangée courante pour le rafraîchissement.

Le constructeur de la DRAM impose la durée de rafraîchissement pour la totalité de la mémoire, généralement 64ms, et donne le nombre de rangées à rafraîchir, par exemple 8K, soit une rangée à rafraîchir toutes les 7.8µs environ.

C'est ensuite à l'utilisateur de déterminer les moments d'insertion des commandes d'auto rafraîchissement les plus propices afin de ne pas trop pénaliser ses propres accès.

Pour cela, il faut tenir compte du fait que cette commande va devoir fermer toutes les rangées encore ouvertes sur toutes les banques afin de rafraîchir la rangée repérée par le compteur de rafraîchissement.

La durée d'une commande d'auto rafraîchissement est généralement d'environ 60 ns, et le rafraîchissement prend entre 1% et 2% de la bande passante totale de la mémoire.

Le compteur de rafraîchissement 50 est relié au multiplexeur 36 avec le registre d'adresse 41, ce qui permet de contrôler les décodeurs 34 pour piloter les bancs 32.

Le résultat de ces opérations est géré au niveau du bus de données 40 par un multiplexeur/démultiplexeur 52. Le multiplexeur/démultiplexeur 52 stocke les valeurs des adresses mémoire lues sur la base des rangées désignées par les décodeurs 34, et des colonnes désignées par des décodeurs 54. Le multiplexeur/démultiplexeur 52 et les décodeurs 54 fonctionnent de tandem à la manière des décodeurs 34 et du multiplexeur 36 pour les accès colonnes.

Le registre d'adresse 41 commande les décodeurs 54. Ces commandes permettent la lecture et l'écriture de données dans les bancs 32. Les échanges de données sur le bus de données 40 sont ensuite gérés par un registre d'entrée/sortie 56 pour communication avec l'extérieur.

Sur le bus de données 40 bidirectionnel se retrouvent les données en provenance ou à destination de tous les bancs de mémoire 32. L'utilisateur doit gérer lui-même l'occupation du bus au cycle près.

Avec les interfaces DRAM de type DDR, il y a deux données par cycle d'horloge, soit une pour chaque front d'horloge. L'essentiel des contraintes est à la charge de l'utilisateur puisqu'il doit fournir à la DRAM, en plus des données, un signal d'échantillonnage par octet de données appelé le DQS, chaque front des DQS servant à échantillonner lesdites données dans la DRAM.

Cela signifie que, en présence de données, les signaux DQS sont identiques au signal d'horloge décalé d'un quart de cycle. En revanche, en sortie, quand la DRAM renvoie les DQS en même temps que les données lues, les fronts des DQS sont synchrones avec l'horloge de retour.

C'est alors encore à l'utilisateur de générer les signaux d'échantillonnage à partir des DQS reçus en utilisant une boucle à verrouillage de délai, également appelée DLL ou Delay Lock Loop.

Lorsque la direction du bus de données 40 est retournée, quelques cycles sont alors perdus pendant lesquels le bus est maintenu en haute impédance, afin d'éviter une mise en court circuit des éléments qui écrivent sur le bus, et en tenant compte des délais de transfert et de synchronisation. Il faut donc éviter de retourner le bus de données 40 trop souvent.

Comme les écritures sont moins sensibles à la latence que les lectures, les contrôleurs de DRAM retardent généralement les écritures afin de les regrouper pour augmenter l'efficacité de la DRAM.

Dans les systèmes intégrés modernes, les bus de données entre les différents éléments présentent un grand nombre de désavantages au nombre desquels on compte une architecture monolithique et un manque d'évolutivité ("scalability" en anglais).

En réaction à cela, des solutions basées sur des réseaux d'interconnexion sur puce, également appelés NoC, ou "Network on Chip" ont été développées. Ces réseaux modernes utilisent des liaisons unidirectionnelles point à point et des commutateurs à leurs noeuds qui permettent de router des paquets d'informations en provenance d'une ou plusieurs liaisons d'entrée vers une ou plusieurs liaisons de sortie. L'arbitrage dans ces réseaux est reparti sur tous leurs noeuds.

Comme cela apparaît dans ce qui précède, les mémoires DRAM sont particulièrement mal adaptées à ce type de solutions. En effet, la nécessité de piloter avec des commandes bas niveau, tout en n'ayant pas de vue directe de l'état du cycle de la DRAM, impose des solutions lourdes et insatisfaisantes en termes de performances.

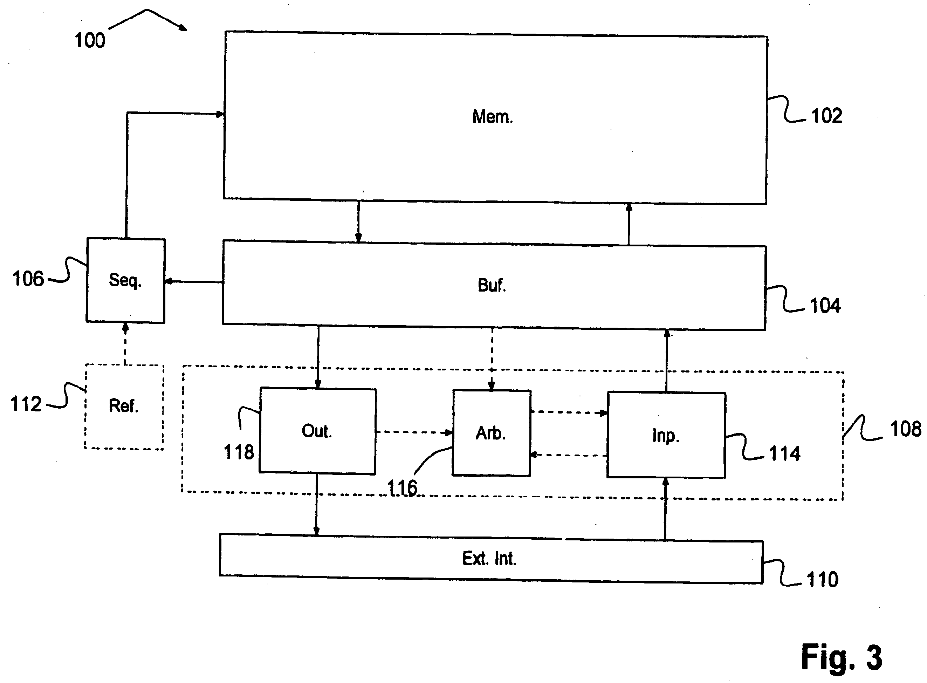

Pour remédier à ces problèmes, la demanderesse a développé une mémoire comme représenté sur la figure 3.

Comme on le voit sur cette figure, un dispositif de mémoire électronique 100 comporte un banc de mémoires 102 de nature dynamique avec un cache 104 de nature statique, un séquenceur 106, un gestionnaire de requêtes 108 et une interface physique 110.

Le banc de mémoires 102 peut comporter un nombre quelconque de banques de mémoire comme décrit avec les figures 1 et 2. Ce nombre est compris entre un et huit, ou plus lorsque cela est réalisable. De manière avantageuse, ce nombre sera limité à 1 dans les modes de réalisation décrit ci-après.

Dans le mode de réalisation décrit ici, le cache 104 est une mémoire distincte du banc de mémoires 102. Dans d'autres modes de réalisation, le cache 104 est constitué par la ligne activée dans la matrice.

Le cache 104 est, comme cela apparaîtra par la suite, du type "copy back", c'est-à-dire que tous les accès à la mémoire 100 passent par lui. Optionnellement, il serait possible d'adapter l'architecture pour utiliser un cache du type "write through".

Dans le cache, une ligne de cache ne correspond pas nécessairement à une rangée du banc de mémoires 102. Une telle rangée peut elle même contenir jusqu'à plusieurs centaines de colonnes. Par contre, la ligne de cache contient assez de colonnes DRAM pour que les temps tels que ceux de précharge, d'accès aux amplificateurs différentiels ou de fin de restauration de la rangée après une écriture colonne (respectivement tRP, tRCD ou tWR) soient répartis sur un nombre d'accès colonne suffisant pour les rendre non significatifs par rapport au temps d'accès de la ligne de cache.

Dans l'exemple ici décrit, une ligne de cache comprend d'une part des données brutes qui correspondent à une zone dans le banc de mémoire 102, et d'autre part un identifiant, ou tag, qui identifie par une adresse à quelle zone du banc de mémoire 102 correspondent ces données. Chaque ligne de cache comporte également un bit de mise à jour et un bit de verrouillage en écriture, dont les rôles seront explicités plus bas.

Le séquenceur 106 a pour rôle la traduction de requêtes de haut niveau (par exemple une requête de lecture d'une adresse particulière sur une longueur donnée) qui lui sont transmises en commandes compréhensibles par la matrice DRAM, c'est-à-dire en requêtes de bas niveau.

Le séquenceur 106 peut être implémenté avec une machine d'état dont les changements d'états ne sont possibles qu'après le comptage d'un nombre de cycles minimum associé à chaque transition d'état, ledit nombre étant spécifié par le concepteur de la DRAM. D'autres implémentations sont également possibles pour le séquenceur 106.

Comme cela apparaîtra plus bas, le séquenceur 106 exécute des requêtes en provenance du cache 104. En option, un module de rafraîchissement 112 gère le rafraîchissement du banc de mémoires 102.

Les commandes pour le rafraîchissement de la matrice peuvent être légèrement ajustées dans le temps afin d'être synchronisées avec les commandes des autres accès demandés. S'il n'y a qu'une seule matrice dynamique, l'accès de rafraîchissement est plus facilement insérable car plus court que pour une mémoire à banques multiples.

Dans d'autres cas, par exemple si la matrice est utilisée exclusivement comme mémoire de trame dans une application de type vidéo avec des accès complets en lecture toutes les 40ms, il est inutile de rajouter des accès de rafraîchissement supplémentaires qui ne ferait qu'augmenter la consommation. Dès lors, le module de rafraîchissement peut être désactivé lors des applications vidéo.

Le gestionnaire de requêtes 108 comporte une file d'attente d'entrée 114, une fonction d'arbitrage 116 et une file d'attente de sortie 118.

les files d'attente d'entrée 114 et de sortie 118 sont toutes les deux reliées par un lien unidirectionnel à l'interface physique 110. Ainsi, toutes les données qui entrent dans le dispositif 100 par l'interface physique 110 sont stockées dans la file d'entrée 114, et toutes les données qui sont émises vers l'extérieur du dispositif sont d'abord stockées dans la file d'attente de sortie 118.

Cette configuration permet d'implémenter un contrôle de flux particulièrement efficace, comme cela apparaîtra plus bas. D'autres configurations restent également possibles.

Dans un mode de réalisation particulier, les files d'attente 114 et 118 stockent l'ensemble des données associées aux requêtes qu'elles reçoivent. De manière classique, les requêtes comportent des données contextuelles (type de requête, adresse, etc.), généralement présentes dans l'en-tête de la requête et le contenu des requêtes, c'est-à-dire les données associées.

Il est également possible de réaliser ces files d'attente en utilisant d'une part des files d'attente qui contiennent uniquement les données contextuelles, et d'autre part une mémoire de stockage, qui contient uniquement le contenu des requêtes, avec un pointeur à chaque fois qui relie chaque requête à son contexte. Cela permet notamment de mutualiser les files d'attente 114 et 118 tout en simplifiant le traitement des requêtes.

La fonction d'arbitrage 116 a pour rôle de gérer l'ordre d'exécution des requêtes contenues dans la file d'attente d'entrée 114 pour optimiser le fonctionnement du dispositif 100.

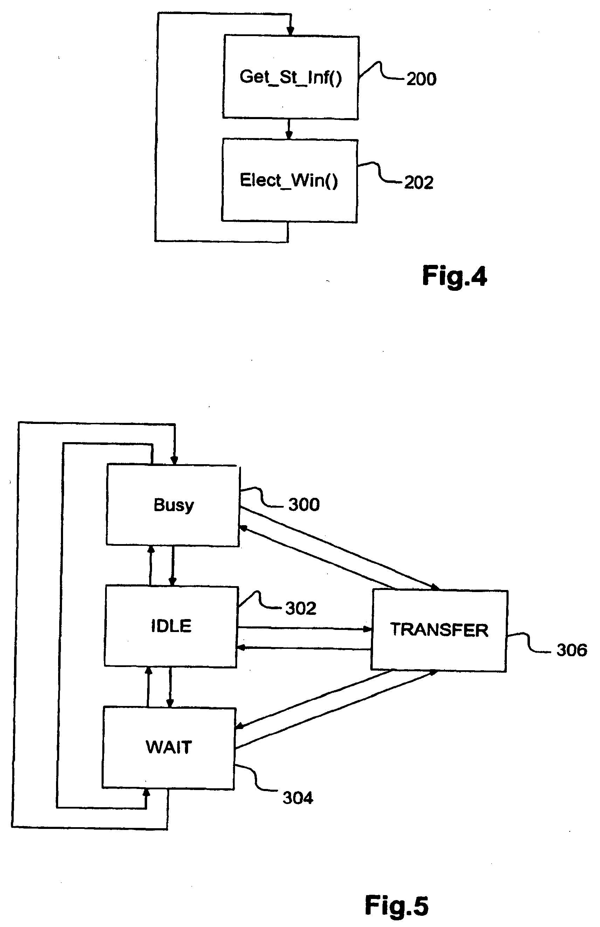

Le fonctionnement de cette fonction va maintenant être explicité avec la figure 4. Comme on peut le voir sur cette figure, la fonction d'arbitrage 116 est une boucle qui commence dans une étape 200 par la réception de données contenant des informations d'état. Ces données sont stockées pour la durée de la boucle au moyen d'une fonction Get_St_Inf().

Ces informations sont reçues sur un certain nombre de ports en entrée, avec un signal de présence de requête par port et éventuellement une priorité associée (généralement 1, max 2 bits).

Dans l'exemple ici décrit, et comme cela apparaît sur la figure 3, les ports d'entrée de la fonction d'arbitrage 116 sont reliés respectivement au cache 104, à la file d'attente d'entrée 114, et à la file d'attente de sortie 118.

Dans tous les cas, la boucle d'arbitrage se termine en 202 avec la fonction Elect_Win (), qui fournit en sortie un signal sur un port de sortie. Dans l'exemple décrit ici, la fonction Elect_Win() comporte plusieurs couches logiques de filtrage ou masquage et un arbitre final.

Par masque, on entend une couche logique qui élimine des requêtes suivant un critère donné. Le masque peut, à un instant donné, éliminer momentanément toutes les requêtes présentes. Par exemple, le séquenceur de gestion d'énergie DRAM peut, pour étaler les pics de courant, masquer à un moment donné toutes les requêtes qui ne font pas « cache hit », c'est-à-dire qui ne sont pas déjà présentes dans le cache.

Par filtre, on entend la sélection de requêtes en fonction d'un critère donné. Dans un filtre, il y a toujours au moins un candidat en sortie s'il y en a au moins un en entrée. Par exemple, un filtre de priorité avec plusieurs niveaux de priorité va d'abord déterminer le niveau de priorité maximum des requêtes présentes, puis sélectionner les requêtes ayant ce niveau.

De manière classique, l'arbitre final choisit parmi les requêtes restantes la requête la plus ancienne et en cas d'égalité sert le port qui a été servi la dernière fois il y a le plus long temps. Un exemple d'implémentation est l'arbitre Arteris faisant l'objet de la demande de brevet FR 2 899 413. Un autre exemple est un arbitre de type « round robbin ».

Les couches en amont de l'arbitre final sont programmables, et dans l'exemple ici décrit, la fonction Elect_Win() en utilise généralement 8 à 10. Changer l'ordre des filtres et des masques donnera des comportements différents, d'où une optimisation possible en fonction de l'application et du NoC de la puce système.

Parmi les couches, on peut trouver :
- un masque de type « lock » : dédie la mémoire pendant tout le temps d'un lock à un seul port (lock : suite de transactions privilégiées, tout le chemin depuis l'initiateur en passant par la target est réservé par l'envoi d'un paquet de type lock et libéré plus tard par un paquet unlock) ;
- un masque de type « fifo room » : analyse la place dans la file de sortie, et interdit d'exécuter une requête si on ne peut réserver la place correspondante pour la réponse ;
- un ou plusieurs filtres de type prioritaire, de plusieurs sortes: selon les bits de priorité dans l'entête de la requête, selon priorité liée à un port (port CPU prioritaire par exemple), etc. ;
- un filtre de type « cache hit » : favorise les requêtes dont les données sont déjà en cache ; et
- un masque de type « power » : masque les requêtes qui font « cache miss » quand la banque mémoire est indisponible, afin de respecter des contraintes liées à la consommation.

Comme on peut le voir sur la figure 3, la fonction d'arbitrage 116 est reliée à la file d'attente d'entrée 114 pour retourner à chaque requête un signal d'élection. Grâce à cette boucle, la fonction d'arbitrage 116 désigne à chaque instant la requête de la file d'attente d'entrée 114 qui devrait être exécutée en priorité.

La décision de transférer ou pas les données liées à la requête élue de la file d'attente d'entrée 114 pour son exécution est une décision par comité qui est liée à un contrôle de flux. Le contrôle de flux est un processus décrit avec la figure 5, qui permet de s'assurer que chaque élément du réseau effectue les bonnes tâches au bon moment.

Le contrôle de flux au niveau du cycle d'horloge est une suite d'échanges d'informations d'états entre des éléments qui communiquent, ces changements d'état renseignant sur le transfert ou non de données entre les éléments. Le contrôle s'exerce sur les mots d'information qui transitent sur les liens de communication point à point entre les éléments constitutifs du dispositif.

Pour éviter une situation de blocage, ou "deadlock", le contrôle de flux décrit ici repose sur le principe de non rétractation de l'un des éléments, soit l'émetteur en amont, soit le récepteur en aval.

Ainsi, chaque élément dans le dispositif 100 émet un signal "valid" vers un élément en aval lorsqu'il place de nouvelles données sur le lien de communication. Après avoir envoyé ce signal, cet élément amont ne peut pas revenir sur cette émission.

Dès lors, l'élément en aval qui est prêt à recevoir les données présentes sur le lien de communication pour les traiter émet son état avec un signal "ready" vers l'amont. L'élément aval prévient ainsi l'élément amont que les données seront échantillonnées et que, par conséquent, ledit élément amont pourra présenter de nouvelles données au cycle d'horloge suivant sur le lien de communication.

De fait, comme tous les éléments du dispositif sont reliés entre eux avec le contrôle de flux, l'ensemble du système intégré peut assurer une haute qualité de service. En effet, de l'extérieur du dispositif 100 jusqu'au séquenceur, la propagation du contrôle de flux garantit la fluidité de circulation des données. Le contrôle de flux au niveau cycle permet de diminuer les besoins en éléments mémorisants lors du transfert d'information dans les puces (on mémorise des mots et non des paquets complets).

Le contrôle de flux est donc une suite d'états décrits comme suit : amont et aval sont utilisés en référence à l'écoulement des données, c'est-à-dire que l'amont fournit des données et l'aval reçoit lesdites données. Un élément amont émet un état "valid" quand de nouvelles données sont présentes et ne peut pas se dédire. L'élément aval va échantillonner lesdites données quand il est prêt à les absorber et notifie en amont son état "ready" qui signifie qu'à la fin du cycle les données présentes sur le lien de communication seront échantillonnées et que par conséquent l'élément amont pourra présenter de nouvelles données. Les signaux "valid" et "ready" sont indépendants et représentent respectivement l'état de l'élément amont et de l'élément aval. Le lien de communication a 4 états :
- Idle 302 : le "valid" n'est pas actif et il n'y a pas de paquet en cours. C'est l'état de repos.
- Wait 304 : Le "valid" n'est pas actif et il y a un paquet en cours (trou dans la fourniture du paquet). L'élément aval doit attendre des données à venir pour compléter le paquet.
- Transfert 306 : on a "Valid" et "ready" actifs. Les données sont effectivement transférées.
- Busy 300 : On a "Valid" et pas "ready". Les données sont présentes mais pas prises par l'élément aval car les moyens de traitement ne sont pas disponibles.
- dans un état 304 ou "wait", l'élément aval B est prêt à recevoir des données et attend des données. L'élément amont A n'est pas "valid" et n'envoie pas de données.

Si l'on considère le cas de la file d'attente d'entrée 114, le contrôle de flux s'opère comme suit.

La file d'attente d'entrée 114 a en permanence, lorsqu'elle est non vide, une requête élue par la fonction d'arbitrage 116. Le rôle de la file d'attente d'entrée 114 est de transmettre cette requête élue au cache 104 pour exécution.

Tant que la file d'attente d'entrée 114 n'est pas pleine, elle envoie vers l'amont un signal "ready" actif et dès que la file est pleine ce signal "ready" est désactivé.

Ici, le signal "valid" peut être par exemple déterminé par la présence d'une requête élue. S'il y a une requête élue et que le cache 104 envoie un signal "ready" actif, chaque mot transféré est effacé de la file 114 et le mot suivant est présenté sur le lien entre ladite file et le cache 104. Si le système est pratiquement vide (une seule requête en écriture dans la file 114 dont toutes les cellules ne sont pas encore reçues), et que le cache 104 étant prêt ("ready" actif) vide la file 114, cette dernière va finir par désactiver son signal "valid".

Dans l'exemple qui est décrit ici, le contrôle de flux et les requêtes ou les réponses qui sont reçues ou émises au niveau de l'interface physique sont directement liés à un protocole de communication créé par la Demanderesse, voir demande de brevet FR 2 900 017.

Ce protocole est particulièrement adapté aux NoC, et vise, entre autres buts, à rendre indépendant le contenu des paquets et la façon dont ces derniers sont transportés afin d'avoir la topologie de réseau la mieux adaptée au transport des paquets.

Ainsi, selon ce protocole, l'en-tête des paquets contient des informations pertinentes à la communication, par exemple la taille de la requête, ce qui permet de réserver un espace dès l'arrivée du premier mot, formant tronçon d'un paquet.

Les paquets en requête ou en réponse ont dans leur en-tête la taille des données associées. Grâce à cela on connaît avant l'arrivée de la fin des paquets la taille nécessaire au stockage des données. Avec ce protocole, les données peuvent être alignées. Les informations transportées peuvent être indépendantes de la structure des liens sur lesquels elles sont transportées. Une requête et la réponse qui lui correspond peuvent être traitées de manière indépendante, de sorte que ce protocole permet un transport amélioré.

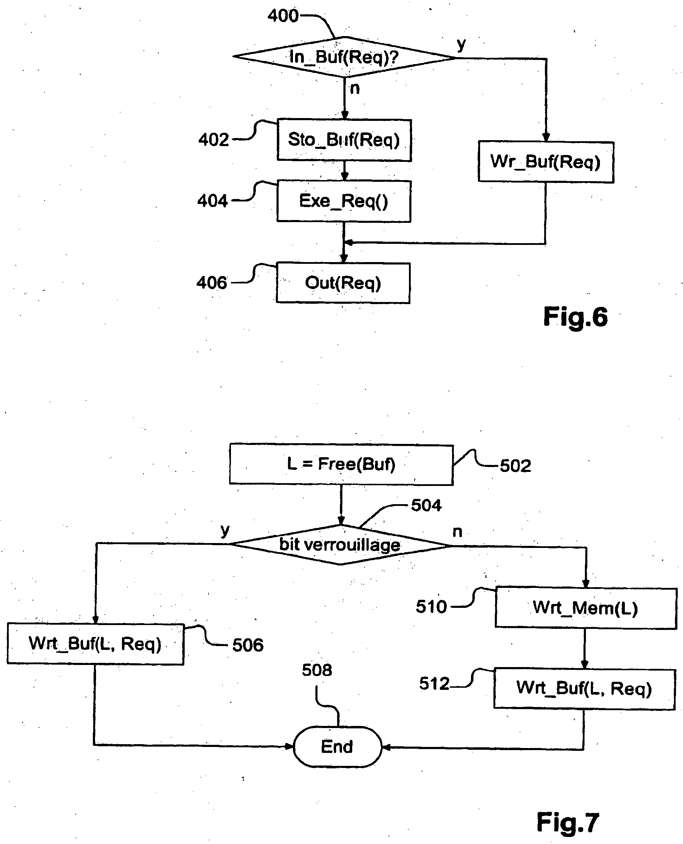

La figure 6 montre un schéma de l'exécution d'une requête élue Req transmise de la file d'attente d'entrée 114 au cache 104.

Dans une étape 400, on vérifie d'abord, grâce au tag associé, que les données correspondantes ne sont pas déjà présentes dans le cache 104 (c'est alors une requête "cache hit") avant de faire un nouvel accès dans le banc de mémoires 102. Si la zone mémoire correspondant au données n'est pas représentée dans le cache 104 (requête "cache miss"), on commence par libérer une ligne de cache afin de l'allouer à ladite zone mémoire, avant de faire un nouvel accès dans le banc de mémoire 102. On utilise alors une fonction Sto_Buf() en 402, explicitée en figure 7.

La fonction Sto_Buf() commence par désigner en 502 une ligne de cache L à libérer.

Pour désigner la ligne à libérer, on peut choisir de libérer en priorité la ligne de nature "cache miss" qui a été accédée le plus anciennement et qui n'est pas verrouillée pour une opération d'écriture. D'autres algorithmes connus de l'homme du métier peuvent également être utilisés, comme la désignation de la ligne "cache hit" qui a été accédée le plus anciennement.

En 504, un test sur le bit de verrouillage est réalisé, pour déterminer si la ligne est libérable ou non. Autrement dit, si la requête précédente associée à ladite ligne était une lecture ou une écriture.

Dans le premier cas, la requête précédente associée à L était une requête de lecture, et la ligne L est donc directement exploitable. Dès lors, dans le cas où la requête courante est une écriture, la fonction Sto_Buf() lance en 506 un accès en écriture sur le cache avec une fonction Wrt_Buf() et stocke les données associées à la requête dans la ligne L. Ensuite la fonction Sto_Buf() se termine en 508 et l'exécution de la requête se poursuit en 404 avec la fonction Exe_Req().

Dans le deuxième cas, la requête précédente associée à L était une requête d'écriture, donc la ligne étant verrouillée, il convient d'abord d'écrire le contenu de la ligne L dans le banc de mémoires. Cela est réalisé en 510 par une fonction Wrt_Mem() qui prend L en tant qu'argument, et écrit dans la matrice le contenu de cette ligne de cache.

Une fois que la ligne L a été écrite dans le banc de mémoires, alors elle devient libre pour recevoir les données de la requête courante Req si c'est une écriture, et la fonction Wrt_Buf() est appelée avec L comme argument en 512. Ensuite la fonction Sto_Buf() se termine en 508 et l'exécution de la requête courante se poursuit en 404 avec la fonction Exe_Req().

La fonction Exe_Req() peut être implémentée de diverses manières. Un exemple d'implémentation consiste dans le cas d'une lecture à écrire la ligne de cache L avec les données correspondantes du banc de mémoire. Dans le cas d'un "cache hit", quand la requête courante est une écriture, les données associées peuvent directement être écrites dans la ligne L.

Si c'est une requête courante de lecture, en cas de "cache miss", alors le banc de mémoires est lu à l'adresse voulue, et la fonction Out_Req() est appelée en 406 avec les données lues. En cas de "cache hit", les données sont lues dans le cache. Si ce n'est pas une requête de lecture, un accusé d'écriture est transmis à la fonction Out_Req(), et les données seront effectivement écrites dans le banc de mémoires lorsque la ligne de cache correspondante sera libérée plus tard.

La fonction Out_Req() qui est appelée en 406 , se contente de recevoir des données du cache, et envoie un "valid" vers la file d'attente de sortie 118 pour transmettre les données de retour associées à la requête qui vient d'être exécutée.

Le rôle des bits de verrouillage et de mise à jour va maintenant être expliqué. Il arrive que certains initiateurs comme les CPU vont chercher à écrire et à lire dans la même ligne de cache.

Si la première requête est une lecture, on peut travailler dans la ligne de cache qui représente alors l'état courant de la mémoire, et le bit de mise à jour est alors actif.

En revanche, si la première requête est une écriture, alors seuls les octets à écrire pourraient être relus directement. Dans ce cas, lors de la lecture, on accède à la rangée associée du banc de mémoires, et, par colonne, octet par octet, en fonction des bits de validation d'octet, on va écrire puis lire sélectivement dans le banc de mémoires pour mettre à jour ce dernier et la ligne de cache.

Le bit de mise à jour activé indique alors que tous les octets représentent l'état courant de la mémoire, tous les bits de validation d'octet sont désactivés ainsi que le bit de verrouillage puisque les écritures ont été faites.

Si une nouvelle requête écrit des données dans la ligne de cache, celle-ci restera à jour mais le bit de verrouillage sera de nouveau activé, ainsi que les bits de validation des octets correspondant.

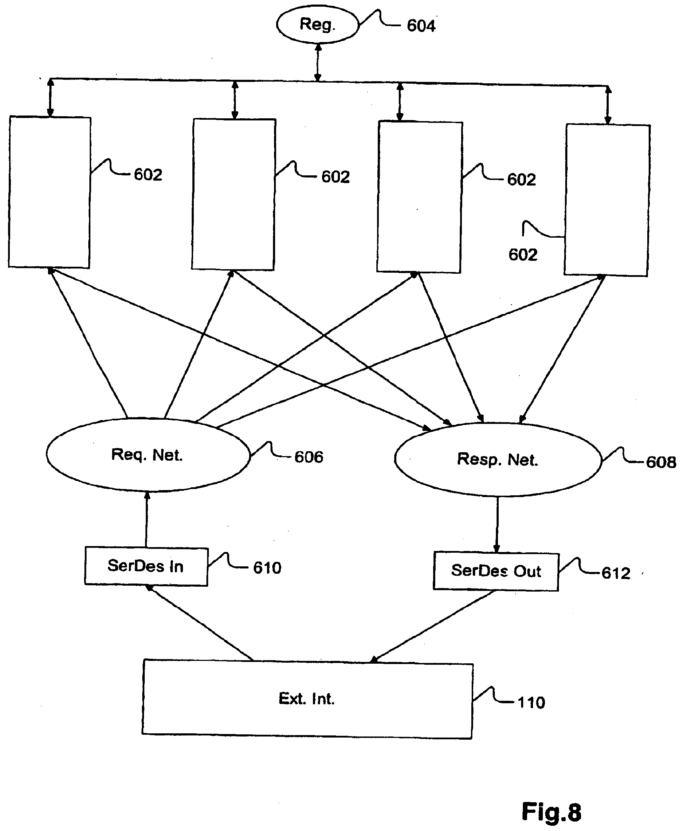

Le dispositif représenté sur la figure 8 constitue un mode de réalisation optimisé pour profiter des avantages offerts par le protocole décrit plus haut.

Pour cela, plusieurs modules de mémoire 602 sont disposés en parallèle. Chaque module 602 correspond à l'ensemble banc de mémoire 102, cache 104, séquenceur 106, fonction d'arbitrage 116, file d'attente d'entrée 114 et file d'attente de sortie 118 de la figure 3. Le banc de mémoire 102 peut contenir un nombre choisi de matrices de mémoire, et adapter ainsi les performances du dispositif à des applications particulières.

Les modules 602 sont tous reliés à un gestionnaire de puissance 604 dont le rôle est d'éviter des pics de courant (dans le cas où tous les modules 602 essaient d'accéder dans leur banc 102 respectif en même temps).

Deux agents de réseau, nommément un agent d'entrée 606 et un agent de sortie 608 sont connectés à chacun des noeuds pour répartir la charge entre les modules 602, et tirer ainsi profit du protocole de communication et de la multiplicité de modules 602. Lesdits agents de réseau peuvent se présenter sous la forme de NoC. Une implémentation simple de l'agent de réseau en entrée est un commutateur à une entrée et n sorties (n étant le nombre de modules 602). Une implémentation simple de l'agent de réseau de sortie est un commutateur à n entrées et une sortie.

Les agents 606 et 608 sont respectivement reliés à un module de désérialisation 610 et à un module de sérialisation 612, ce qui permet d'avoir des liaisons séries de haut débit.

Les agents 606 et 608 peuvent en outre être complétés par d'autres agents, qui peuvent par exemple permettre d'implémenter des politiques de sécurité ou de qualité de service, comme cela est possible grâce au protocole de communication.

La description qui précède donne quelques modes de réalisation. Néanmoins, la portée de l'invention s'étend à l'ensemble des combinaisons des caractéristiques décrites ci-dessus ainsi qu'à leurs équivalents.

## Revendications

1. Dispositif de mémoire électronique, comportant
un banc de mémoires (102) muni d'un cache (104), et un séquenceur pour assurer les accès physiques audit banc de mémoires (102), ainsi qu'une interface physique (110) pour recevoir des requêtes d'accès mémoire de haut niveau, et un gestionnaire de requêtes, **caractérisé en ce que** le gestionnaire de requêtes (108) comprend une file d'attente d'entrée (114) pour stocker les requêtes d'accès mémoire de haut niveau, une fonction d'arbitrage (116) qui tient compte de données du cache (104) et de données de la file d'attente d'entrée (114) pour désigner une requête à exécuter et une file d'attente de sortie (118) pour recevoir des données de requête exécutée, permettant ainsi de réaliser les bancs de mémoire (102), le séquenceur (106) et le gestionnaire de requêtes (108) sur une puce unique, la puce comprenant des liaisons unidirectionnelles point à point de transport de requêtes de haut niveau, les files d'attente d'entrée (114) et de sortie (118) étant toutes les deux reliées par un lien unidirectionnel à l'interface physique (110) l'interface physique assurant la connexion avec l'extérieur de la puce toutes les données qui entrent dans le dispositif (100) par l'interface physique (110) étant stockées dans la file d'entrée (114), et toutes les données qui sont émises vers l'extérieur du dispositif étant d'abord stockées dans la file d'attente de sortie (118).

2. Dispositif selon la revendication 1, **caractérisé en ce que** la fonction d'arbitrage (116) tient également compte de données de la file d'attente de sortie (118) pour désigner la requête à exécuter.

3. Dispositif selon la revendication 1 ou 2, **caractérisé en ce qu'**il comporte un cache (104) entre les bancs de mémoire (32) et la file d'attente d'entrée (114).

4. Dispositif selon l'une des revendications précédentes, **caractérisé en ce que** la fonction d'arbitrage (116) comporte des masques de sélection.

5. Dispositif selon l'une des revendications précédentes, **caractérisé en ce que** la fonction d'arbitrage (116) comporte des filtres de sélection.

6. Dispositif selon l'une des revendications précédentes, **caractérisé en ce qu'**il comporte plusieurs modules (602) comportant chacun un banc de mémoire (102), une file d'attente d'entrée (114), une file d'attente de sortie (118) et un cache, ainsi qu'un gestionnaire de modules (604) relié à chacun des modules (602), et disposé entre l'interface physique (110) et les modules (602).

7. Dispositif selon la revendication 6, **caractérisé en ce que** le gestionnaire de modules (604) comporte un agent de réseau d'entrée (606) et un agent de réseau de sortie (608) reliés à chaque module, lesdits agents étant disposés entre l'interface physique (110) et les modules (602).

8. Dispositif selon la revendication 7, **caractérisé en ce qu'**il comporte un module de dé-sérialisation (610) entre l'interface physique (110) et l'agent de réseau d'entrée (606), et un module de sérialisation (612) entre l'agent de réseau de sortie (608) et l'interface physique (110).

9. Dispositif selon l'une des revendications précédentes, **caractérisé en ce que** le banc de mémoires (102) est une mémoire DRAM.

10. Dispositif selon l'une des revendications précédentes, **caractérisé en ce qu'**il reçoit et émet des messages selon un protocole de transport choisi pour communication avec un NoC.

## Patentansprüche

1. Elektronische Speichervorrichtung aufweisend
eine Speicherbank (102) mit einem Cache (104) und eine Ablaufsteuerung zum Bereitstellen physikalischer Zugriffe auf die Speicherbank (102), sowie eine physikalische Schnittstelle (110) zum Empfangen von Speicherzugriffsanfragen hoher Ebene, und einen Anfragenmanager,
**dadurch gekennzeichnet, dass** der Anfragenmanager (108) eine Eingangswarteschlange (114) aufweist zum Speichern der Speicherzugriffsanfragen hoher Ebene, eine Arbitragefunktion (116), welche Daten des Cache (104) und Daten der Eingangswarteschlange (114) Rechnung trägt, um eine auszuführende Anfrage zu bestimmen, und eine Ausgangswarteschlange (118) zum Empfangen von Daten einer ausgeführten Anfrage, so dass ermöglicht wird, die Speicherbänke (102), die Ablaufsteuerung (106) und den Anfragenmanager (108) auf einem einzigen Chip zu realisieren, wobei der Chip unidirektionale Punkt-zu-Punkt-Anschlüsse aufweist zum Transportieren von Anfragen hoher Ebene, wobei die Eingangswarteschlange (114) und die Ausgangswarteschlange (118) beide durch einen unidirektionalen Link mit der physikalischen Schnittstelle (110) verbunden sind, wobei die physikalische Schnittstelle die Verbindung des Chips nach außen sicherstellt, wobei alle Daten, die über die physikalische Schnittstelle (110) in die Vorrichtung (100) gelangen, in der Eingangswarteschlange (114) gespeichert werden, und alle Daten, die von der Vorrichtung nach außen geschickt werden, zunächst in der Ausgangswarteschlange (118) gespeichert werden.

2. Vorrichtung gemäß Anspruch 1, **dadurch gekennzeichnet, dass** die Arbitragefunktion (116) auch Daten der Ausgangswarteschlange (118) Rechnung trägt, um die auszuführende Anfrage zu bestimmen.

3. Vorrichtung gemäß Anspruch 1 oder 2, **dadurch gekennzeichnet, dass** sie einen Cache (104) zwischen den Speicherbänken (32) und der Eingangswarteschlange (114) umfasst.

4. Vorrichtung gemäß einem der vorhergehenden Ansprüche, **dadurch gekennzeichnet, dass** die Arbitragefunktion (116) Auswahlmasken umfasst.

5. Vorrichtung gemäß einem der vorhergehenden Ansprüche, **dadurch gekennzeichnet, dass** die Arbitragefunktion (116) Auswahlfilter aufweist.

6. Vorrichtung gemäß einem der vorhergehenden Ansprüche, **dadurch gekennzeichnet, dass** sie mehrere Module (602) umfasst, wobei jedes eine Speicherbank (102), eine Eingangswarteschlange (114), eine Ausgangswarteschlange (118) und einen Cache aufweist, sowie einen Modulmanager (604), der mit jedem der Module (602) verbunden ist, und zwischen der physikalischen Schnittstelle (110) und den Modulen (602) angeordnet ist.

7. Vorrichtung nach Anspruch 6, **dadurch gekennzeichnet, dass** der Modulmanager (604) einen Eingangsnetzwerkagenten (606) und einen Ausgangsnetzwerkagenten (608) umfasst, die mit jedem Modul verbunden sind, wobei die genannten Agenten zwischen der physikalischen Schnittstelle (110) und den Modulen (602) angeordnet sind.

8. Vorrichtung gemäß Anspruch 7, **dadurch gekennzeichnet, dass** sie ein Deserealisierungsmodul (610) zwischen der physikalischen Schnittstelle (110) und dem Eingangsnetzwerkagenten (606) aufweist, und ein Serealisierungsmodul (612) zwischen dem Ausgangsnetzwerkagenten (608) und der physikalischen Schnittstelle (110).

9. Vorrichtung gemäß einem der vorhergehenden Ansprüche, **dadurch gekennzeichnet, dass** die Speicherbank (102) ein DRAM Speicher ist.

10. Vorrichtung gemäß einem der vorhergehenden Ansprüche, **dadurch gekennzeichnet, dass** es Nachrichten gemäß einem zur Kommunikation mit einem NoC ausgewählten Transportprotokoll empfängt und sendet.

## Claims

1. Electronic memory device, comprising
a bank of memories (102) provided with a cache (104), and a sequencer for providing physical access to said bank of memories (102), as well as a physical interface (110) for receiving high level memory access requests, and a request manager, **characterized in that** the request manager (108) comprises an input queue (114) for storing the high level memory access requests, an arbitration function (116) which takes account of data of the cache (104) and data of the input queue (114) so as to designate a request which is to be executed and an output queue (118) for receiving data of an executed request, thus allowing the memory banks (102), the sequencer (106) and the request manager (108) to be realized on a single chip, the chip comprising unidirectional point-to-point lines for transporting high level requests, the input queue (114) and output queue (118) being both connected by a unidirectional link to the physical interface (110), the physical interface providing a connection between the chip and the outside, wherein all the data entering the device (100) via the physical interface (110) are stored in the input queue (114), and all the data sent out of the device are initially stored in the output queue (118).

2. Device according to claim 1, **characterized in that** the arbitration function (116) also takes account of data of the output queue (118) to designate the request which is to be executed.

3. Device according to claim 1 or 2, **characterized in that** it comprises a cache (104) between the memory banks (32) and the input queue (114).

4. Device according to one of the preceding claims, **characterized in that** the arbitration function (116) comprises selection masks.

5. Device according to one of the preceding claims, **characterized in that** the arbitration function (116) comprises selection filters.

6. Device according to one of the preceding claims, **characterized in that** it comprises a plurality of modules (602) each comprising a memory bank (102), an input queue (114), an output queue (118) and a cache, as well as a module manager (604) connected to each of the modules (602) and arranged between the physical interface (110) and the modules (602).

7. Device according to claim 6, **characterized in that** the module manager (604) comprises an input network agent (606) and an output network agent (608) connected to each module, said agents being arranged between the physical interface (110) and the modules (602).

8. Device according to claim 7, **characterized in that** it comprises a deserialization module (610) between the physical interface (110) and the input network agent (606), and a serialization module (612) between the output network agent (608) and the physical interface (110).

9. Device according to one of the preceding claims, **characterized in that** the bank of memories (102) is a DRAM memory.

10. Device according to one of the preceding claims, **characterized in that** it receives and sends messages according to a transportation protocol selected for communication with an NoC.
